# EUROPEAN PATENT APPLICATION

(11) **EP 3 422 526 A1**
(43) Date of publication of application: **02.01.2019**
(21) Application number: 17305801.7
(22) Date of filing: 27.06.2017
(51) Int. Cl.: H02J 7/00, B60L 11/18, G01R 31/36, H01M 10/48, H02J 7/04

(54) **BATTERY MONITORING AND CONTROL SYSTEM**

(71) Applicant: EH Europe GmbH, 6300 Zug (CH)
(72) Inventor: DUHAUT, Francis, 62033 Arras (FR); LINET, Christophe, 62033 Arras (FR); BEAUCAMP, François, 62033 Arras (FR)
(74) Representative: Abel & Imray

(57) **Abstract**

The invention concerns a battery control system (10), and a wireless battery control device (16). The wireless battery control device (16) is connected to a battery harness (14), and comprises a current sensor (18) and voltage sensor (20); a wireless battery temperature sensor (26); a wireless battery electrolyte level sensor (24); and a wireless battery vibration sensor (30). The wireless battery control device (16) is configured to receive and record data from each of the temperature, electrolyte level, and vibration sensors (26, 24,30), and transmit that data to one or more external recording devices (32). The wireless battery control device (16) sends a battery charging profile to a battery charger (34) and is further configured to control the discharge of the battery (12).

## Description

### Field of the Invention

The present invention concerns battery control devices. More particularly, but not exclusively, this invention concerns wireless battery control devices, and systems for controlling the charging and discharging of batteries.

### Background of the Invention

In order to maintain an efficiently charged set of batteries, for example in a warehouse where many batteries are used for driving fork-lift trucks, it is necessary to monitor the use of those batteries, and charge the batteries accordingly. This may involve using different charging profiles based on the present state or historical usage of the battery. Various existing battery control devices exist, which involve wired connection to the battery being controlled in order to monitor the various battery parameters which effect which battery charging profile should be used. However, existing systems may be time consuming and difficult to add to a battery.

The present invention seeks to mitigate the above-mentioned problems. Alternatively or additionally, the present invention seeks to provide an improved battery control device and battery control system.

### Summary of the Invention

The present invention provides, according to a first aspect, a battery control system, the battery control system comprising:
a battery with a battery harness;
a wireless battery control device connected to the battery harness, the wireless battery control device comprising a current and voltage sensor;
a wireless battery temperature sensor;
a wireless battery electrolyte level sensor; and
a wireless battery vibration sensor;
wherein the wireless battery control device is configured to receive and record data from each of the temperature, electrolyte level, and vibration sensors, and transmit that data to one or more external recording devices,
the wireless battery control device further configured to communicate with a battery charger, such that the wireless battery control device sends a battery charging profile to the battery charger, and
the wireless battery control device further configured to control the discharge of the battery.

The wireless battery control device, the wireless temperature sensor, the wireless battery electrolyte sensor, and wireless battery vibration sensor may be configured for wireless communication via any or all of the WI-FI, Bluetooth, or ZIGBEE, communication protocols, or any other suitable communication protocol.

The battery control system may comprise a smart device, located remotely from the battery and wireless battery control device, arranged to receive data from the wireless battery control device. The smart device may be configured to send data, for example charging profiles, to the wireless battery control device. The smart device may be a tablet device or a smart phone. The smart device may be a computer arranged to receive wireless signals, or connected to a receiving device which is arranged to receive wireless signals.

The wireless battery control device may be configured to analyse the data received from the various sensors in order to devise the optimum charging profile for the battery. Alternatively, the data may be sent to an external processing device which analyses the data and devises the optimum charging profile for the battery. The external processing device may be arranged to send the optimum charging profile to the wireless battery control device, which in turn sends the charging profile to a battery charger.

The battery may be a lead-acid battery. The battery may be a 12V lead-acid battery comprising a plurality of lead plates. The battery may be configured for providing motive power to electric vehicles, for example fork lift trucks which may be used in warehouses.

According to a second aspect of the invention there is also provided a wireless battery control device comprising:
an attachment mechanism arranged to attach the wireless battery control device to a battery harness;
a current sensor,
a voltage sensor,
a processing unit,
a memory,
and at least one wireless communication module.

The wireless communication module may be a WI-FI communication module, a Bluetooth communication module, a ZIGBEE communication module, or any other suitable wireless communication module. The battery control device may comprise a plurality of wireless communication modules. The plurality of wireless communication modules may be different types of wireless communication modules such that communication with an increased number of external devices is facilitated.

The attachment mechanism may comprise an approximately cylindrical aperture, arranged to be fastened around the battery harness. The aperture may have a longitudinal axis, running in parallel with the length of the battery harness. The current sensor may be arranged to be coaxial with the attachment mechanism. The voltage sensor may comprise a pair of pins, the pins separated along the length of the longitudinal axis of the attachment mechanism. The wireless battery control device may comprise a CANbus to allow the various electronic elements of the device to communicate with each other. Such an arrangement will be easily appreciated by the skilled person.

A wireless battery control device according to the second aspect may easily be installed on a battery by being fixed to a battery harness, without the need for any additional wiring.

The wireless battery control device may be easily configured for communication with other wireless apparatus, with a simple wireless pairing process preferred. This pairing process may be triggered by activation of a pairing function on either or both of the wireless battery control device and the other wireless apparatus. The wireless battery control device may be configured for wireless communication with one or more of a wireless temperature sensor, wireless battery electrolyte level sensor, and wireless vibration sensor, each sensor being arranged to take a corresponding measurement of a battery. The wireless battery control device may be configured to monitor the readings being taken by the wireless sensors and send an alarm signal should one or more of the readings reach a potentially damaging level. For example, an alarm may be triggered if the wireless temperature sensor detects a battery is getting too hot or too cold. The alarm may be a notification sent to an external monitoring device, for example a smart device. Alternatively or additionally, the alarm may be an activation signal sent to an audible or visual alarm unit.

According to a third aspect, there is provided a method of controlling a battery charging process, the method comprising the steps of:
providing a battery comprising a battery harness,
attaching a wireless battery control device according to the second aspect of the invention to the battery harness,
monitoring the discharge of the battery using the wireless battery control device,
based on the battery discharge characteristics, formulating a suitable charging profile,
connecting the battery to a battery charger,
the wireless battery control device sending the suitable charging profile to the battery charger,
whereupon the battery charger charges the battery according to said charging profile.

The method may include the steps of the wireless battery control device sending discharge information to an external processing unit, for example in a smart device or remote computer. The smart device or remote computer may analyse the battery discharge information in order to generate a suitable, and preferably optimal, charging profile. The charging profile may then be communicated to the wireless battery charging device. Alternatively, the wireless battery charging device may comprise a processing unit arranged to analyse the battery discharge information in order to generate a suitable, and preferably optimal, charging profile. The suitable, and preferably optimal charging profile may be calculated based on the battery discharge information for each charge/discharge cycle, or may be selected from a number of predetermined battery charging profiles stored in the wireless battery charging device or external processing unit.

It will of course be appreciated that features described in relation to one aspect of the present invention may be incorporated into other aspects of the present invention. For example, the method of the invention may incorporate any of the features described with reference to the apparatus of the invention and *vice versa.*

### Description of the Drawings

Embodiments of the present invention will now be described by way of example only with reference to the accompanying schematic drawings of which:
- Figure 1: shows a schematic view of a battery control system according to a first embodiment of the invention;
- Figure 2: shows a schematic view of a battery control device which may be used in the first embodiment of the invention; and
- Figure 3: shows a cross-sectional view of a battery control device as shown in figure 2, and a battery monitoring device.

### Detailed Description

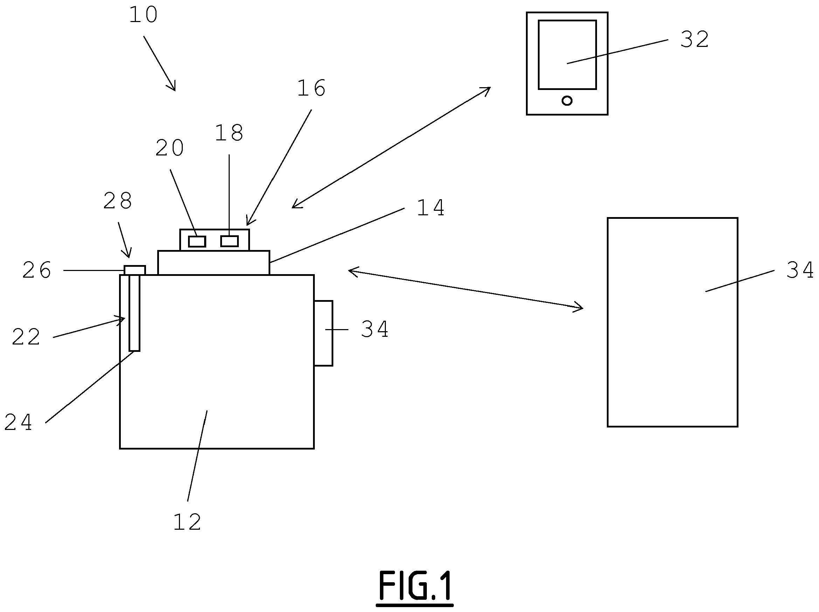

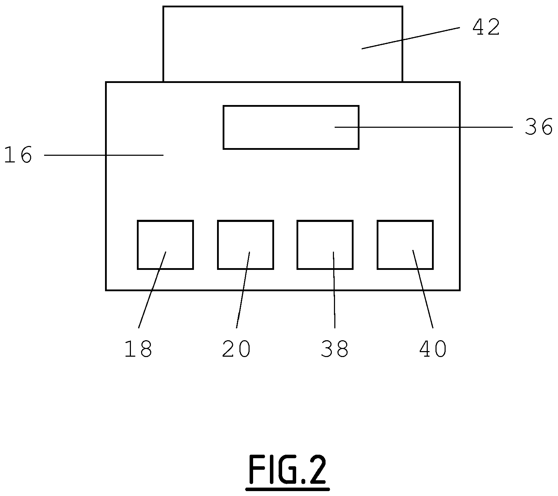

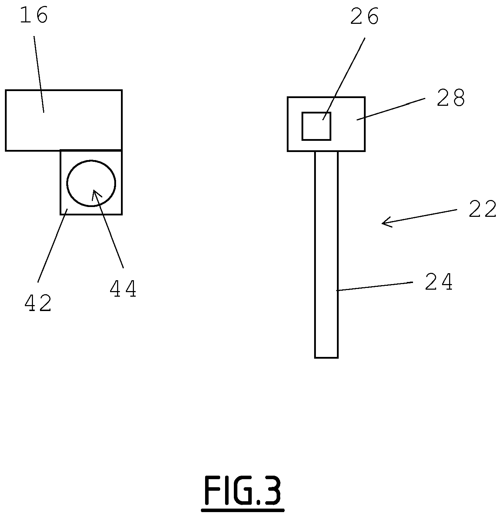

Figure 1 shows a battery control system 10. A lead-acid battery 12 is provided with a battery harness 14. A battery control device 16 is mounted to the battery harness 14. The battery control device 16 comprises a ring section as further described with reference to figure 3, which allows the battery control device 16 to be placed around the battery harness 14 without the need to make any direct electrical connection between the battery harness 14 and the battery control device 16. The battery control device 16 comprises a current sensor 18 and a voltage sensor 20. The current sensor 18 and voltage sensor 20 are respectively arranged to monitor the current and voltage either being applied to the battery 12 in a charging process, or being supplied by the battery 12 during a battery discharge process. A battery monitoring device 22 comprises an electrolyte sensor 24 in the form of a lead probe extending into the battery 12, with a temperature sensor 26 also forming part of the battery monitoring device 22. Thus the battery monitoring device may detect the electrolyte levels within the battery 12 and also the temperature of the battery 12. A head unit 28 of the battery monitoring device 22 is arranged to collect the readings obtained by the electrolyte sensor 24 and the temperature sensor 26, and wirelessly transmit that data to the battery control device 16. A vibration sensor 30 is also mounted on the battery 12, and is arranged to wirelessly transmit vibration data to the battery control device 16. The battery control system 10 also comprises a remote recording device 32, for example a smart phone, tablet, or computer, configured to wirelessly communicate (for example receiving and/or sending data) with the battery control device 16. The battery control device 16 comprises a wireless communications module which is explained in more detail with reference to figure 2. The data sent from the battery control device 16 to the remote recording device 32 may be data received from any of the sensors comprising, or communicating with, the battery control device 16. The data sent from the remote recording device 32 to the battery control device 16 may include information regarding preferred charging profiles for use during battery charging, for example in dependence on an analysis of the use of the battery. The battery control system 10 may also comprise a battery charging station 34, configured such that when the battery 12 is connected to the battery charging station 34, the battery charging station recharges the battery 12. The battery charging station 34 is configured to wirelessly communicate (for example, receiving and/or sending data) with the battery control device 16. The data communicated between the battery control device 16 and the battery charging station 34 may comprise information regarding the preferred charging profiles for use during battery charging, and data relating to the actual charging profiles applied during the charging process. Such data may be used by the battery charging station 34, or the battery control device 16, or the remote recording device 32, to determine the optimum charging profile for the battery 12. The various elements of the battery control system may be linked together via a simple "pairing" of the devices, such as is conventional, for example, when two devices communicate via Bluetooth <RTM>.

Figure 2 shows a schematic view of the battery control device 16. In addition to the current sensor 18 and voltage sensor 18, the battery control device 16 comprises a wireless communications module 36, a CPU 38, a memory 40, and an attachment mechanism 42. A CANbus (not shown) may connect all of the elements together to allow communication between the elements. The wireless communications module 36 is configured for at least one mode of wireless communication, for example, Bluetooth <RTM>, WI-FI, ZIGBEE, NFC, or any other suitable wireless communication as would be understood by the skilled person. The wireless communications module 36 may be arranged to both receive communications from the various sensors associated with the battery 12, the remote recording device 32, and the charger 34, and also send communications to those elements. The CPU 38 is arranged to control the operations of the battery control device 16, as would be understood by the skilled person. The memory 40 is arranged to store data relating to the operation of the battery control device 16, including, for example, the sensor data received, the operating conditions of the battery 12, and the charging history of the battery 12. The attachment mechanism 42, as best shown in figure 3, comprises a hooped portion which may be clamped around the battery harness 14. The current sensor 18 and voltage sensor 20 may be associated, or form part of, the hooped portion of the attachment mechanism 42. The battery control device 16 may comprise a small power supply in order to allow operation of the device, or alternatively drawn a small amount of power from the battery 12 to which is it connected and controls. Figure 3 also shows a cross-sectional view of the battery monitoring device 22. The hooped portion of the battery control device 16 may comprise two spaced metal pins, the metal pins arranged to detect the voltage running through the battery harness 14, when the battery control device is clamped in place.

The battery control system 10 may be configured for use in a variety of different ways. For example, when the battery is installed and in use, for example to provide motive power to an electric vehicle, the battery control device may be arranged to monitor the current, voltage, temperature, electrolyte levels, and/or vibration levels of the usage, and record that data in the memory of the battery control device. The battery control device 16 may then use that data to calculate the optimum charging profile for the battery 12 when connected to the battery charger 34. Alternatively, or additionally, the battery control unit 16 may send that data to the remote recording device 32, which may store and analyse the data provided. The battery control device may also be used to monitor and/or control the charging profile supplied by the battery charger 34 during a charging unit. A further external unit, for example a smart phone or tablet device, may be used to wirelessly communicate with the battery control device 16 in order to change the configuration and/or operational parameters of the battery control device 16. The battery control device 16 may be arranged to include visual or audible signalling devices, such as one or more LED or buzzer, which may be triggered in the event that an undesirable battery condition is detected. Such a condition may be, for example, discharge below a certain voltage level, a drop in electrolyte, or an excessively high or low operational temperature. Therefore, there is provided a highly adaptable, and multifunctional, battery control system. A large number of operations may be performed by the battery control system without requiring wired communication, and easy configuration changes may be made without having to spend a significant amount of time adjusting the hardware involved. Therefore, set up and operation of the battery control system is quick, easy, and economical to do.

Whilst the present invention has been described and illustrated with reference to particular embodiments, it will be appreciated by those of ordinary skill in the art that the invention lends itself to many different variations not specifically illustrated herein. By way of example only, certain possible variations will now be described. The remote recording device may be a remote dashboard for an electric vehicle to which the battery is connected and providing motive power. Such an arrangement may allow an operator of the vehicle to easily assess the condition of the battery and tailor their usage of the vehicle accordingly.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may not be desirable, and may therefore be absent, in other embodiments.

## Claims

1. A battery control system, the battery control system comprising:
a battery with a battery harness;
a wireless battery control device connected to the battery harness, the wireless battery control device comprising a current and voltage sensor;
a wireless battery temperature sensor;
a wireless battery electrolyte level sensor; and
a wireless battery vibration sensor;
wherein the wireless battery control device is configured to receive and record data from each of the temperature, electrolyte level, and vibration sensors, and transmit that data to one or more external recording devices,
the wireless battery control device further configured to communicate with a battery charger, such that the wireless battery control device sends a battery charging profile to the battery charger, and
the wireless battery control device further configured to control the discharge of the battery.

2. A battery control system as claimed in claim 1, comprising a smart device, located remotely from the battery and wireless battery control device, arranged to receive data from the wireless battery control device.

3. A battery control system as claimed in claim 2, wherein the smart device is configured to send data, to the wireless battery control device.

4. A battery control system as claimed in any preceding claim, wherein the wireless battery control device is configured to analyse the data received from the various sensors in order to devise the optimum charging profile for the battery.

5. A battery control system as claimed in any of claims 1 to 3, configured such that data is sent to an external processing device which analyses the data and devises the optimum charging profile for the battery.

6. A battery control system as claimed in any preceding claim, wherein the battery is a lead-acid battery.

7. A battery control system as claimed in any preceding claim, wherein the battery is configured for providing motive power to electric vehicles.

8. A wireless battery control device comprising:
an attachment mechanism arranged to attach the wireless battery control device to a battery harness;
a current sensor,
a voltage sensor,
a processing unit,
a memory,
and at least one wireless communication module.

9. A wireless battery control device as claimed in claim 8, wherein the attachment mechanism comprises an approximately cylindrical aperture, arranged to be fastened around the battery harness.

10. A wireless battery control device as claimed in claim 8 or claim 9, wherein the voltage sensor comprises a pair of pins.

11. A wireless battery control device as claimed in any of claims 8 to 10, configured for wireless communication with one or more of a wireless temperature sensor, wireless battery electrolyte level sensor, and wireless vibration sensor, each sensor being arranged to take a corresponding measurement of a battery.

12. A wireless battery control device as claimed in claim 11, configured to monitor the readings being taken by the wireless sensors and send an alarm signal should one or more of the readings reach a potentially damaging level.

13. A method of controlling a battery charging process, the method comprising the steps of:
providing a battery comprising a battery harness,
attaching a wireless battery control device according to the second aspect of the invention to the battery harness,
monitoring the discharge of the battery using the wireless battery control device,
based on the battery discharge characteristics, formulating a suitable charging profile,
connecting the battery to a battery charger,
the wireless battery control device sending the suitable charging profile to the battery charger,
whereupon the battery charger charges the battery according to said charging profile.

14. A method of controlling a battery charging process as claimed in claim 13, wherein the method includes the steps of the wireless battery control device sending discharge information to an external processing unit.

15. A method of controlling a battery charging process as claimed in claim 13, wherein the wireless battery charging device comprises a processing unit arranged to analyse the battery discharge information in order to generate a charging profile.
